# DEMANDE DE BREVET EUROPEEN

(11) **EP 4 087 073 A1**
(43) Date de publication de la demande: **09.11.2022**
(21) Numéro de dépôt: 22169760.0
(22) Date de dépôt: 25.04.2022
(51) Int. Cl.: H02B 5/02, H05K 7/18

(54) **PIECE DE FIXATION UNIVERSELLE ET PROCEDE DE FIXATION ASSOCIE**

(30) Priorité: 03.05.2021 FR 2104646
(71) Demandeur: Nexans, 92400 Courbevoie (FR)
(72) Inventeur: DEVAUX, Julien, 08160 Chalandry-Elaire (FR); MIART, Freddy, 08000 Charleville-Mezières (FR)
(74) Mandataire: Ipsilon

(57) **Abrégé**

Cette pièce (10) de fixation comporte une surface (12) de fixation réalisée dans une matière déformable et qui présente au moins un trou (14) de fixation et au moins une paire de découpes (16) alignées dégageant chacune une languette (18) de fixation ayant une partie libre (20), les parties libres (20) des languettes (18) de fixation de l'au moins une paire de découpes (16) étant situées à des extrémités opposées des languettes (18).

## Description

La présente invention se rapporte à une pièce de fixation universelle et à un procédé de fixation associé.

L'invention appartient au domaine des équipements de télécommunications.

Les boîtiers de raccordement aériens et souterrains, ainsi que leurs accessoires de gestion de câbles, tels que des croix de lovage ou des panneaux de brassage extérieurs, sont des équipements généralement installés sur des supports de formes très variées. Ces supports peuvent être des parois en fosse ou des façades, présentant donc des surfaces planes, ou des poteaux, à section cylindrique ou polygonale.

Cela oblige actuellement à créer des pièces spécifiquement adaptées pour servir d'interface entre les boîtiers ou accessoires et leurs supports, afin de permettre une installation facile et efficace des boîtiers et accessoires.

En outre, contrairement aux surfaces planes, les poteaux nécessitent de prévoir un appui en forme de V pour interdire la rotation de l'ensemble accroché et permettre un alignement propre avec l'axe longitudinal du poteau.

L'accrochage et le guidage sur les formes de section cylindrique ou polygonale oblige à prévoir une pièce d'accrochage intermédiaire supplémentaire avec une forme en V en relief ou à créer cette forme en V directement sur la pièce d'interface entre l'équipement à fixer et le support.

L'ajout de cette pièce de guidage en V ou de cette forme en relief éloigne l'équipement de son support. Cela est préjudiciable au regard des contraintes dues au poids propre de l'équipement installé, qui peut provoquer un effet d'affaissement dans le temps et également au regard des contraintes climatiques, comme le vent continu ou en bourrasques, qui induisent des faiblesses de fatigue.

La présente invention a pour but de remédier aux inconvénients précités de l'art antérieur.

Dans ce but, la présente invention propose une pièce de fixation comportant une surface de fixation, remarquable en ce que la surface de fixation est réalisée dans une matière déformable et présente au moins un trou de fixation et au moins une paire de découpes alignées dégageant chacune une languette de fixation ayant une partie libre, les parties libres des languettes de fixation de l'au moins une paire de découpes étant situées à des extrémités opposées des languettes.

Ainsi, l'équipement à installer est au plus près de son support, ce qui évite l'affaissement au fil du temps et le développement de fragilités dues aux contraintes mécaniques.

La pièce de fixation conforme à l'invention constitue donc un système de centrage non déporté qui peut être directement intégré à l'équipement à accrocher et qui peut être utilisé quelle que soit la géométrie de la surface du support, notamment que celle-ci soit plane ou que le support ait une section rectangulaire, polygonale ou cylindrique.

C'est donc une solution de fixation universelle, convenant à toute forme de support.

En outre, le montage d'un équipement sur un support grâce à cette pièce de fixation est simplifié du fait de l'assemblage direct sur le support.

Par ailleurs, la suppression de toute pièce de guidage intermédiaire réduit le coût de la fixation.

Dans un mode particulier de réalisation, la pièce de fixation présente deux trous de fixation.

Au cas où la surface du support est plane, cela permet de fixer la pièce très simplement par vissage au travers des trous de fixation.

Dans un mode particulier de réalisation, la pièce de fixation présente deux paires de découpes parallèles.

Cela augmente la sécurité de la fixation au support, car chaque paire de découpes peut recevoir un élément de bridage à fixer au support, ce qui offre donc deux hauteurs différentes de fixation.

Dans le même but que celui indiqué plus haut, la présente invention propose également un procédé de fixation d'un équipement de télécommunications sur un support présentant une géométrie prédéterminée, remarquable en ce qu'il comporte des étapes consistant à :
intégrer sur l'équipement de télécommunications une pièce de fixation telle que décrite succinctement ci-dessus;
fixer l'ensemble formé par l'équipement de télécommunications et la pièce de fixation sur le support, les languettes de fixation venant épouser la forme du support.

Dans un mode particulier de réalisation du procédé où la géométrie du support est à section rectangulaire, polygonale ou cylindrique, l'étape de fixation comporte une étape consistant à brider la pièce de fixation sur le support en insérant au moins un élément de bridage dans l'au moins une paire de découpes et en fixant l'au moins un élément de bridage sur le support.

Selon une première variante de réalisation, l'au moins un élément de bridage peut être un feuillard métallique.

Selon une seconde variante de réalisation, l'au moins un élément de bridage peut être un collier de serrage.

Dans un mode particulier de réalisation du procédé où la géométrie du support est plane, l'étape de fixation comporte une étape consistant à insérer au moins un élément de fixation dans l'au moins un trou de fixation et dans le support.

Selon une caractéristique particulière possible, l'au moins un élément de fixation peut être une vis.

Dans des modes particuliers de réalisation du procédé, l'équipement de télécommunications peut être un boîtier de raccordement de câbles de télécommunications ou une croix de lovage ou un panneau de brassage extérieur.

Le procédé offrant les mêmes avantages que la pièce de fixation, ceux-ci ne sont pas rappelés ici.

### Brève description des dessins

D'autres aspects et avantages de l'invention apparaîtront à la lecture de la description détaillée ci-après de modes particuliers de réalisation, donnés à titre d'exemples nullement limitatifs, en référence aux dessins annexés, dans lesquels :
[Fig. 1] est une représentation schématique d'une pièce de fixation conforme à la présente invention, dans un mode particulier de réalisation, dans un cas de fixation sur un support plan ;
[Fig. 2] est une représentation schématique d'une pièce de fixation conforme à la présente invention, dans un mode particulier de réalisation, dans un cas de fixation sur un support à section rectangulaire ;
[Fig. 3] est une représentation schématique d'une pièce de fixation conforme à la présente invention, dans un mode particulier de réalisation, dans un cas de fixation sur un support à section cylindrique ;
[Fig. 4] est une représentation schématique d'une pièce de fixation conforme à la présente invention, dans un mode particulier de réalisation adapté à la fixation d'une croix de lovage ;
[Fig. 5] est une représentation schématique d'une pièce de fixation conforme à la présente invention, dans un mode particulier de réalisation adapté à la fixation d'un panneau de brassage extérieur ;
[Fig. 6] est un organigramme illustrant des étapes d'un procédé de fixation conforme à la présente invention, dans un mode particulier de réalisation.

### Description de mode(s) de réalisation

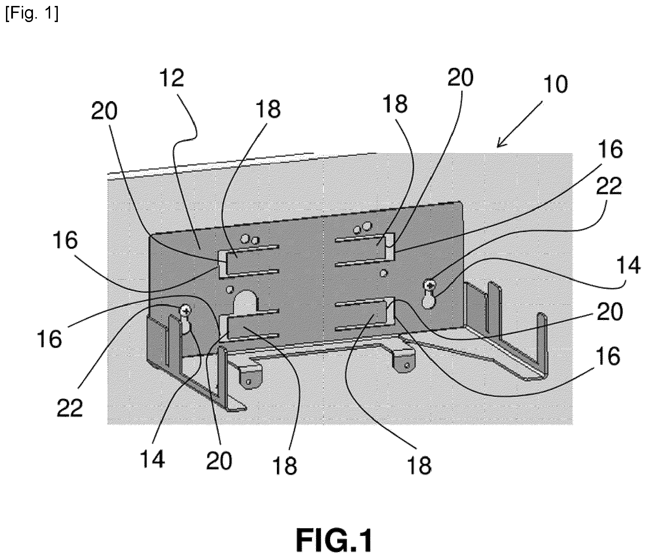

Comme le montre la figure 1, dans un mode particulier de réalisation, une pièce 10 de fixation conforme à la présente invention comporte une surface 12 de fixation.

Conformément à la présente invention, la surface 12 de fixation est réalisée dans une matière déformable. Cette matière peut être métallique ou plastique, ces exemples n'étant cependant pas limitatifs. En outre, la surface 12 de fixation présente un ou plusieurs trous 14 de fixation et une ou plusieurs paires de découpes 16.

La surface 12 de fixation peut par exemple comporter deux trous 14 de fixation, comme dans le mode de réalisation de la figure 1.

Les découpes 16 de chaque paire sont alignées. Chaque découpe 16 dégage une languette 18 de fixation qui a une partie libre 20.

Pour une paire de découpes 16 donnée, les parties libres 20 des languettes 18 de fixation sont situées à des extrémités opposées des languettes 18.

Dans le mode de réalisation de la figure 1, la pièce 10 de fixation présente deux paires de découpes 16 disposées de façon que les deux découpes 16 d'une même paire sont alignées horizontalement et les découpes 16 d'un même côté de chaque paire sont alignées verticalement. Autrement dit, les deux paires de découpes 16 sont parallèles. Cette disposition n'est toutefois pas limitative et d'autres agencements peuvent être envisagés.

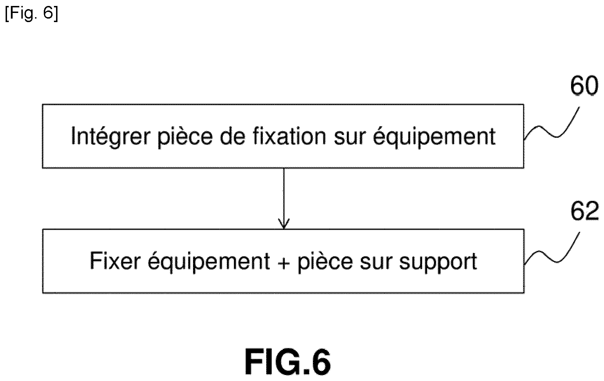

Comme le montre l'organigramme de la figure 6, dans un mode particulier de réalisation, un procédé conforme à la présente invention, de fixation d'un équipement de télécommunications sur un support présentant une géométrie prédéterminée, comporte une première étape 60 consistant à intégrer sur l'équipement de télécommunications la pièce 10 de fixation décrite ci-dessus.

A titre d'exemple nullement limitatif, l'équipement de télécommunications peut être un boîtier de raccordement de câbles de télécommunications, ou une croix de lovage, ou encore un panneau de brassage extérieur.

L'étape 60 d'intégration peut être réalisée par tout moyen jugé approprié. Par exemple, des trous additionnels de fixation peuvent être prévus dans la pièce 10 de fixation à cet effet, pour solidariser la pièce 10 de fixation et l'équipement de télécommunications par l'intermédiaire d'éléments de fixation tels que vis, écrous ou boulons venant s'insérer dans ces trous.

Puis une étape 62 consiste à fixer l'ensemble formé par l'équipement de télécommunications et la pièce 10 de fixation sur le support. Lors de cette étape 62, les languettes 18 de fixation viennent épouser la forme du support.

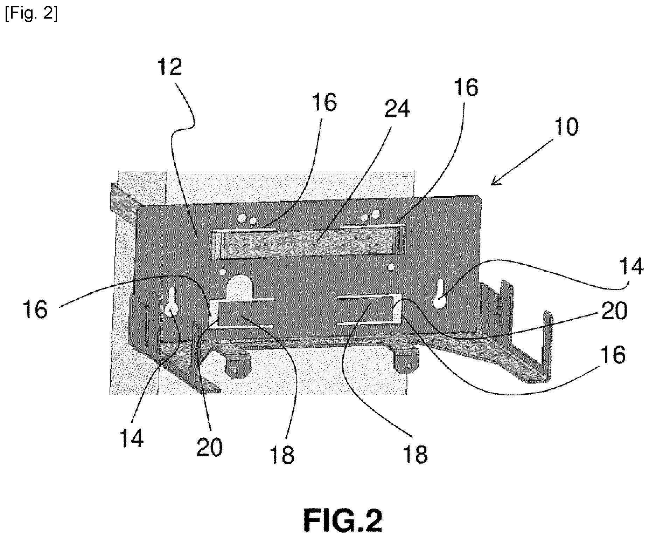

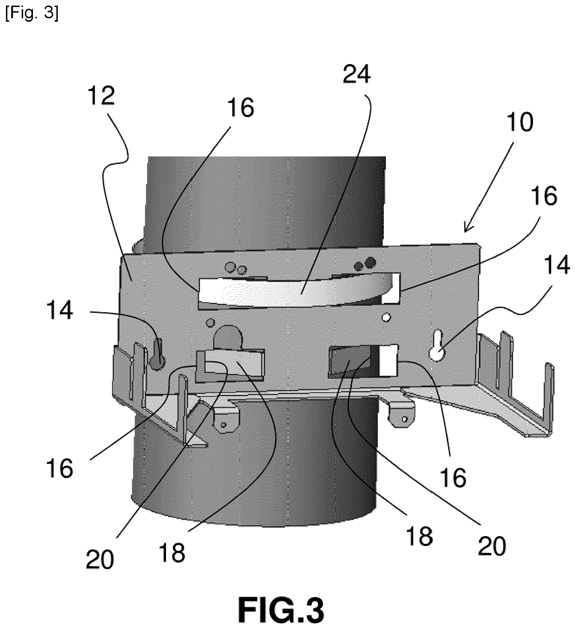

Ainsi, si la géométrie du support est à section rectangulaire comme sur la figure 2, polygonale, ou cylindrique comme sur la figure 3, dans un mode particulier de réalisation, l'étape 62 de fixation comporte une étape consistant à brider la pièce 10 de fixation sur le support en insérant au moins un élément 24 de bridage dans l'au moins une paire de découpes 16 et en fixant l'au moins un élément 24 de bridage sur le support. A titre d'exemple nullement limitatif, l'élément 24 de bridage peut être un feuillard métallique ou un collier de serrage.

Si la géométrie du support est plane, dans un autre mode particulier de réalisation, comme celui de la figure 1, l'étape 62 de fixation comporte une étape comporte une étape consistant à insérer au moins un élément de fixation dans le ou les trous 14 de fixation et dans le support. A titre d'exemple nullement limitatif, l'au moins un élément de fixation peut être une vis. L'ensemble formé par la pièce de support et l'équipement de télécommunications est donc dans ce cas vissé sur le support et les languettes 18 de fixation restent dans le plan des découpes 16.

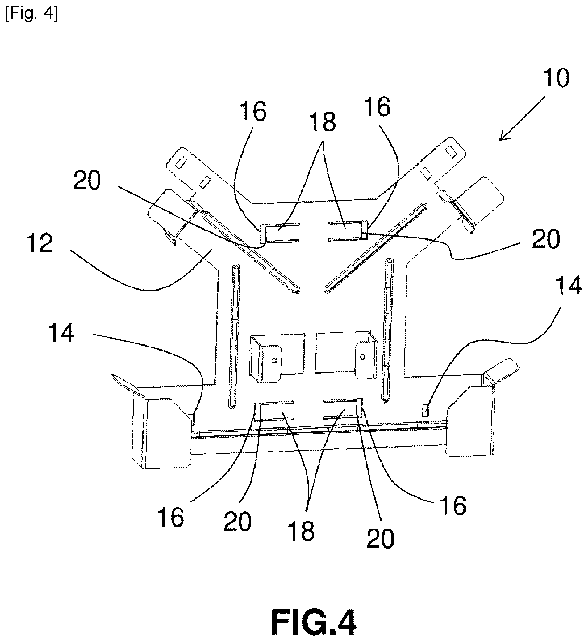

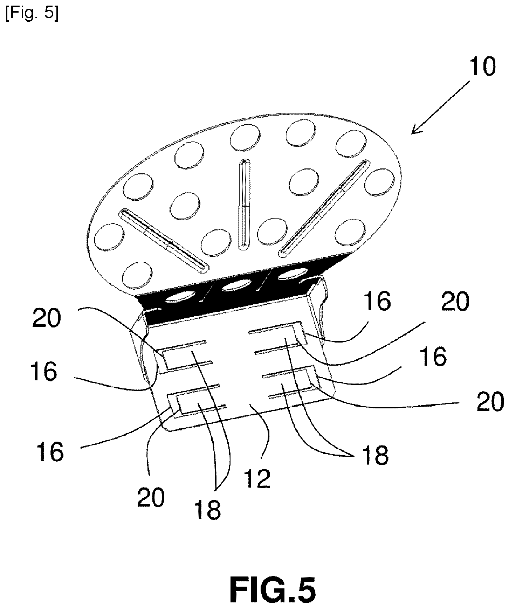

Les figures 4 et 5 illustrent d'autres exemples de pièces 10 de fixation, dont la forme présente des adaptations qui conviennent particulièrement bien à certains types d'équipements de télécommunications. Ainsi, la figure 4 illustre une pièce 10 de fixation adaptée à être intégrée sur une croix de lovage et la figure 5 illustre une pièce 10 de fixation adaptée à être intégrée sur un panneau de brassage extérieur. Néanmoins, ces exemples ne sont nullement limitatifs et la pièce 10 de fixation peut être tout autre accessoire.

La pièce 10 de fixation et le procédé de fixation conformes à la présente invention peuvent s'appliquer à des équipements souterrains ou aériens et à une grande variété d'équipements de télécommunications allant du central téléphonique jusqu'à des bâtiments d'habitation. On peut même envisager d'autres domaines d'application, y compris sans rapport avec les télécomuunications.

## Revendications

1. Pièce (10) de fixation comportant une surface (12) de fixation, **caractérisée en ce que** ladite surface (12) de fixation est réalisée dans une matière déformable et présente au moins un trou (14) de fixation et au moins une paire de découpes (16) alignées dégageant chacune une languette (18) de fixation ayant une partie libre (20), les parties libres (20) des languettes (18) de fixation de ladite au moins une paire de découpes (16) étant situées à des extrémités opposées desdites languettes (18).

2. Pièce (10) de fixation selon la revendication 1, **caractérisée en ce qu'**elle présente deux trous (14) de fixation.

3. Pièce (10) de fixation selon la revendication 1 ou 2, **caractérisée en ce qu'**elle présente deux paires de découpes (16) parallèles.

4. Procédé de fixation d'un équipement de télécommunications sur un support présentant une géométrie prédéterminée, **caractérisé en ce qu'**il comporte des étapes consistant à :
intégrer (60) sur ledit équipement de télécommunications une pièce (10) de fixation selon l'une quelconque des revendications précédentes ;
fixer (62) l'ensemble formé par ledit équipement de télécommunications et ladite pièce (10) de fixation sur ledit support, lesdites languettes (18) de fixation venant épouser la forme dudit support.

5. Procédé selon la revendication 4, ladite géométrie étant à section rectangulaire, polygonale ou cylindrique, **caractérisé en ce que** ladite étape (62) de fixation comporte une étape consistant à brider ladite pièce (10) de fixation sur ledit support en insérant au moins un élément (24) de bridage dans ladite au moins une paire de découpes (16) et en fixant ledit au moins un élément (24) de bridage sur ledit support.

6. Procédé selon la revendication 5, **caractérisé en ce que** ledit au moins un élément (24) de bridage est un feuillard métallique.

7. Procédé selon la revendication 5, **caractérisé en ce que** ledit au moins un élément (24) de bridage est un collier de serrage.

8. Procédé selon la revendication 4, ladite géométrie étant plane, **caractérisé en ce que** ladite étape (62) de fixation comporte une étape consistant à insérer au moins un élément de fixation dans ledit au moins un trou (14) de fixation et dans ledit support.

9. Procédé selon la revendication 8, **caractérisé en ce que** ledit au moins un élément de fixation est une vis.

10. Procédé selon l'une quelconque des revendications 4 à 9, **caractérisé en ce que** ledit équipement de télécommunications est un boîtier de raccordement de câbles de télécommunications ou une croix de lovage ou un panneau de brassage extérieur.
